# EUROPEAN PATENT SPECIFICATION

(11) **EP 3 920 391 B1**
(45) Date of publication and mention of the grant of the patent: **05.08.2026**
(21) Application number: 20178201.8
(22) Date of filing: 04.06.2020
(51) Int. Cl.: H02M 1/12, H02M 1/32, H02J 1/02, H02J 7/34

(54) **MOTOR DRIVE UNIT WITH INPUT EMI FILTER**
MOTORANTRIEBSEINHEIT MIT EINGANGS-EMI-FILTER
UNITÉ D'ENTRAÎNEMENT MOTEUR AVEC FILTRE EMI D'ENTRÉE

(43) Date of publication of application: 08.12.2021
(73) Proprietor: TE Connectivity Solutions GmbH, 8200 Schaffhausen (CH)
(72) Inventor: Amaducci, Alessandro, 4543 Deitingen (CH)
(74) Representative: P&TS SA (AG, Ltd.)

(56) References cited:
- EP-A1- 3 496 251
- EP-A2- 2 814 153
- JP-A- 2019 062 640
- US-A- 4 093 900
- US-A1- 2019 006 941

## Description

### Technical domain

The present invention relates to a filter for electromagnetic interferences.

### Related art

Electric systems in vehicles and in industry are becoming ever more complex and include ever more parts that generate, or are liable to be disturbed by, electromagnetic interferences. AC Electric motors, for example, are driven by electronic inverters that control the motor speed and torque by generating waveform with variable frequencies and voltages. These systems provide high efficiency but generate a powerful electromagnetic noise.

Sometimes, other kind of electric motors, such as DC brushless motors, are used, and some motors are controlled by generating trapezoidal waves, or by DC/DC converters.

Switching power converters are used to drive electric motors in electric vehicles and in hybrid electric vehicles, as well as in countless applications such as driving of stationary motors, battery chargers, photovoltaic systems, lighting control, high-performance computers, and many other applications. In all these cases, the switching action of the converter is a source of electromagnetic noise that must be mitigated by EMI filters.

US20180269781, for example, disclose a power filter that of this kind, designed for an automotive application.

EMI filter, inverters, and power electronic systems invariably include reactive elements that can store energy, for example as residual charge in capacitors. Safety considerations and many technical norms require that the filter include dissipative elements, for example bleeding resistors, that cause the energy stored to discharge spontaneously. To limit energy losses, however, the ohmic values of the bleeding resistor are chosen as high as possible, and the discharge is rather slow.

The persistence of residual energy in electronic devices, can be the source of several problems. In electric vehicles, a high-voltage DC bus connects the battery pack to high-voltage components, such as the motor drive system. The HVDC bus must be discharged at certain times. For instance, in some vehicles the HVDC bus must be discharged to a safe level, e.g. below 60 V within a stated time after a key-off event. Safety considerations notwithstanding, residual energy in electronic devices can be detrimental in many ways. For example, several advanced drive systems may have transient failure modes that could be dealt with better with a means for rapidly dissipating the residual energy.

US7944161 discloses a drive system with a DC link and an inverter for driving an AC motor, wherein the inverter is configured to discharge the DC link, on request, by injecting ripple currents in the motor's windings. US9018865, JP2019062640A, EP3496251, US4093900 disclose active discharge resistors for an electric vehicles and motors.

Another case in which an ability to dissipate energy quickly may be desirable is that of regenerative braking. This technique is used both in electric vehicles and in stationary applications (for example in elevators) and consists in using an AC motor as a generator and sending the electric energy that it produces into a storage device. In this way, a braking torque is generated.

When the storage device in a regenerative braking system reaches its maximum capacity, or in case of malfunctions, the energy produced by the motor must be dissipated in some other way, to maintain the braking torque. It is known to use in these cases a braking resistor. Braking resistors, however, are bulky, expensive, and require substantial cooling to function.

The problems linked to residual energy in electronic devices are not limited to motor drive systems is vehicles, but arise in many power applications, and the invention can be applied to battery charging and several other fields.

### Short disclosure of the invention

An aim of the present invention is the provision of a device that overcomes the shortcomings and limitations of the state of the art.

According to the invention, these aims are attained by the object of the attached independent claim 1.

Among the claimed features, a heat dissipator or heat sink is in thermal contact with the power resistor, either directly, or through a metallic enclosure of the filter or through a busbar. Preferably, a thermal pad or thermal paste is placed between the power resistor and the heat dissipator or heat sink to improve the Thermal Exchange Coefficient therebetween. This disposition is advantageous, since it uses existing elements to provide an excellent thermal dissipation path to the active discharge resistor. The filter of the invention may also comprise a grounded conductor for protection, which may be electrically equipotential with the metallic enclosure.

The invention has also variants in which the power resistor is connected to a controlled switch that may be internal to the filter, or an external component. In the former case, the filter has a discharge signal terminal that accepts, for example, a logical level from a controlling unit, and determine a discharge of the DC bus on which the filter is connected. In the latter case, the filter has a discharge terminal with high current capabilities, for connection to an external switch.

The filter is installed on a motor drive unit of the electric vehicle and filter the DC drive train at the supply point of the motor drive unit. Thus, the power dissipated in the resistor during a discharge is readily conducted, by the filter's enclosure to the cooling system of the drive unit.

Additionally, the active discharge resistor needs to be connected between the positive and negative conductors of the DC bus, as are many components of the EMI filter - for example the "X" capacitors - Therefore, the active discharge resistor can be conveniently put into the EMI filter with no or little increase in size or cost, while an external component may be difficult to place in installations where space is at a premium, such as in vehicles.

It has been realized by the inventor that, although the functions of the EMI filter and of the discharge device are quite different, their requirements are compatible, for instance for what the thermal management is concerned. Integrating an active discharge device in the EMI filter provides a synergistic advantage leading to cost and space savings.

In this disclosure, the indication "high voltage" indicates a voltage level that is considered high in the automotive industry, that is, any voltage higher than the voltage of the auxiliary equipment of the vehicle, e.g. 12 or 24 V. DC voltages above 60 V are generally considered "high voltage" in vehicles. Conversely, DC voltage levels lower than 60 V are considered "safe". In many vehicles the HV drive train has a nominal value between 275 and 800 V, but higher and lower values are known.

The indications "electrically connected" and "thermally connected" include, in the present disclosure, the case of two components that are connected directly, and arrangements in which two elements exchange electric or thermal energy though an intermediate third component.

### Short description of the drawings

Exemplar embodiments of the invention are disclosed in the description and illustrated by the drawings in which:
Figure 1 illustrates schematically, in single line representation, the circuit of an electric vehicle;
Figure 2 is a simplified representation of an EMI filter for a DC power line;
Figure 3 illustrates an embodiment of the present invention with an external switch;
Figure 4 illustrates an embodiment of the present invention with an internal switch.

### Examples of embodiments of the present invention

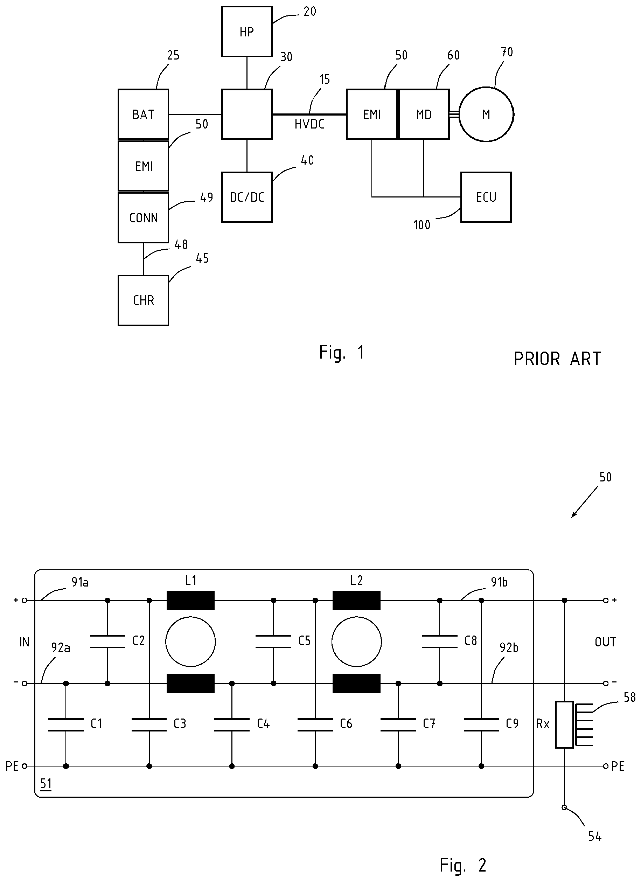

Figure 1 shows in a very simplified fashion, the main components of an electric vehicle. The energy necessary to the traction is stored in a battery pack 45 and may be replenished by the charger 45 or - in the case of a hybrid vehicle - by a non-illustrated combustion motor. The battery pack 25 is connected to a power distribution unit 30 that distributes the power to various loads, for instance an DC/DC converter 40 for generating a 12V voltage for auxiliary equipment (entertainment, lights, on-board computers, etc.), and heat pumps 20 for the heating/ear conditioning. Importantly, a high-voltage DC bus 15 transmits the voltage of the battery to a motor drive unit 60 that includes an inverter generating multiphase AC waveforms suitable for the electric traction motor 70. An EMI filter 50 is inserted on the DC bus 15 at the supply point of the drive unit 60 to filter out the noise generated by the inverter in the latter.

The configuration of figure 1 is just one among the various possibilities and is provided merely as a non-limiting example of one possible use of the invention. The invention may be used in electric vehicles presenting various configurations, for example in series-hybrid, parallel-hybrid, plug-in-hybrid configurations that do not correspond to the diagram of figure 1. The invention is not limited to automotive applications, either.

Figure 1 shows two EMI filters 50, one between battery 25 and charging connector 49, and one on the DC side of the motor drive 60. The inventive EMI filter may be used in other positions without leaving the scope of the invention. Meaningful locations for EMI filters are: after the charger 45, after the battery 25, before the DC/DC converter 40. The charging unit 45 may be totally or in part installed after the connector 49. All these variants are included in the scope of the invention defined by the appended claims.

Figure 2 shows a possible structure of the EMI filter 50. The schematics is simplified, and an industrial realization of an EMI filter a may be significantly different including, for example, other inductors beside the current-compensated ones, damping resistor in series with the capacitors or at other suitable positions, and "Y" capacitors. The presented structure is provided merely as a non-limitative example of an embodiment of the invention.

The filter is connected on the DC bus 15 by means of the input positive and negative terminals 91a, 91b on the battery side, and the positive and negative output terminals 91b 92b on the load side. The indications "input" and "output" are purely conventional and refer to the conventional direction of energy flow from the battery to the motor, but it is not in fact important. In the presented example, the filter network 51 is a symmetric two-stage LC filter, which would work in the same way if reversed, and is arranged to filter noise from and to the motor drive unit. According to the filter's current rating, the input and output terminals may be interconnected by printed traces, cables, solid conductive busbars, or any other suitable conductor.

The filter comprises an earth conductor PE, preferably equipotential with an enclosure of the filter, for protection.

The filter network 51 comprises in general a plurality of inductors and capacitors. In the presented example, they are represented by two current-compensated chokes L1 and L2, by the "X" capacitors C1-C9, which contribute, together with the capacitors included in the motor drive unit 60, to the energy that can be stored in the DC bus 15.

The dissipative element Rx is included in the EMI filter for the purpose of discharging the DC bus 15 in all the circumstances that may warrant it. The dissipative element Rx may be a power resistor, or any other electric component capable of dissipating power. Its value is determined by the total capacity present on the DC bus 15, the desired time constant, and the total energy that must be dissipated at each discharge but, in a non-limiting automotive application, it may have a resistance value between 1 kΩ and 10 kΩ. One terminal of the resistor Rx is connected to one of the input or output terminals of the DC bus, and the resistor is in thermal contact with a structure 58 capable of dissipating or storing the heat generated in the discharge. According to the circuit's dimensioning, the heat dissipator 58 may be an individual radiator or a metallic enclosure of the filter 50, or a busbar. Note that the dissipative element Rx may be connected to the input side of the filter 50, rather than to the output side as drawn, without changes in function and effect.

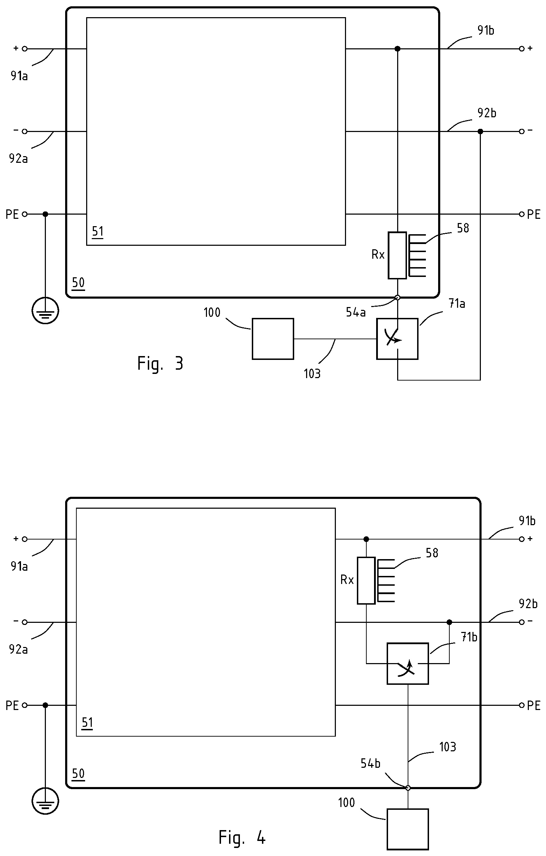

The power resistor Rx is not permanently and directly connected with both terminals across the DC bus 15, but switching means are interposed such that the DC bus 15 can be discharged on command. The switching means can be a transistor, for example an IGBT or a power MOSFET, a controlled rectifier, an electromechanical relay, or any suitable controllable switch. Figures 3 and 4 show two possible variants of the invention with an external switch 71a, or an internal one 71b.

In the variant of figure 3, the power resistor Rx is connected to a discharge terminal 54a of the EMI filter 50, which is dimensioned to carry the discharge current, while the external switch 71a is connected internally between the discharge terminal 54a and, externally, to the negative output terminal 92b or vice versa. Note that the switch 71a could be connected to the input terminals 92a, 92b in an alternative realization.

In the variant of figure 4, the switch 71b is included in the filter 50, and the filter has a signal terminal 54b that accepts a signal, for example a logical level, upon which the switch 71b is activated, and the DC bus is discharged. In this case, the signal terminal 71b must not handle significant currents. The signal 103 can be generated by an ECU 100, or by any suitable logic circuit. The signal terminal 54b may be arranged to accept a logical level, an analogue level, a serial data, a digital bus, an optical fibre, or any suitable form of electronic communication.

In a particularly significant use case, the filter of the invention is inserted between the battery pack and the motor drive unit of an electric vehicle, as shown in figure 1. The motor drive unit 60 may have a considerable input capacity, and the filter 50 is arranged and dimensioned to discharge that capacity as well as its own internal capacities C1-C9. The filter 50 may be fastened to a metallic enclosure of the motor drive unit that, in turn, is actively cooled, for example by a liquid circulation system. In this manner, the thermal losses in the filter and the energy dissipated in the resistor Rx whenever the DC bus 15 is discharged are transmitted to and dissipated by the motor drive unit 60.

The present invention is not limited to on-board applications in vehicles but extends to all technical applications of EMI filters requiring the dissipation of residual energy. The invention can be used to dissipate the residual energy in the dissipative element Rx whenever a predetermined trigger condition is encountered, for example when a connector is unplugged, or a safety cover is removed. The dissipative element Rx will be dimensioned to bring the voltage in the DC conductor to a safe level (for example below 60 V) in a stated time (for example 1 s).

An embodiment of the invention relates to improving the safety of charging installations for electric vehicles. As illustrated in figure 1, an electric vehicle may have a connector 49 for connecting the battery 25 to a charger 45, with interposed an EMI filter 50 and a charging cable 48.

It is desirable, and may be required, that the conductors in the cable 48 be brought to a safe level of voltage (for example less than 60 V) within a stated time (for example 1 s) after the unplugging of the connector 49. To this purpose, the charging unit is equipped with a filter according to the invention, either with an internal switch as in figure 4, **or** with an external one as in figure 3. The charging unit includes a logic circuit 100 configured to detect the unplugging of the connector 49 and generate a discharge signal 103, whereby the switch 71a or 71b is closed to discharge the power conductors 91a, 91b.

### Reference symbols in the figures

- 12: DC link
- 20: heat pump
- 25: battery pack
- 40: DC/DC converter
- 45: charger
- 48: charging cable
- 49: connector
- 50: EMI filter
- 51: filter network
- 54a: discharge terminal
- 54b: discharge signal terminal
- 58: heat dissipator/heat sink
- 60: motor drive unit
- 70: AC motor
- 71a: external switch
- 71b: internal switch
- 91a: input positive terminal of the EMI filter
- 91b: output positive terminal of the EMI filter
- 92a: input negative terminal of the EMI filter
- 92b: output negative terminal of the EMI filter
- 100: logic circuit, electronic control unit
- 103: discharge signal
- C1-C8: capacitors
- L1-L2: current-compensated chokes
- PE: protective earth
- Rx: dissipative element/power resistor

## Claims

1. A motor drive system (50, 60) for an electric vehicle, comprising a motor drive unit (60) and a filter (50) and being configured to be connected to a DC power line (15) via the filter, the filter comprising positive and negative input terminals (91a, 92a) for connecting the filter to the DC power line, and positive and negative output terminals (91b, 92b) for connecting the filter to the motor drive unit, a filtering circuit (51), arranged to filter out a noise component on the DC power line (15), **characterized by** a dissipative element (Rx) in the filter (50) which is selectively connectable between one positive input or output terminal (91a, 91b) and one respective negative input or output terminal (92a, 92b), wherein the dissipative element (Rx) is in thermal contact with a heat dissipator that is a metallic enclosure of the filter (50), the filter (50) being fastened to a metallic enclosure of the motor drive unit (60) that is configured to be actively cooled.

2. The motor drive system of the preceding claim, comprising a protective earth (PE).

3. The motor drive system of any one of the preceding claims, wherein the dissipative element (Rx) is in thermal contact with a heat sink (58).

4. The motor drive system of the preceding claim, wherein the heat dissipator or heat sink (58) is in thermal contact with the dissipative element (Rx) through a thermally conductive enclosure of the filter (50).

5. The motor drive system of any one of claims 3 to 4, wherein the filter further comprises a thermal pad or thermal paste placed between the dissipative element (Rx) and the heat dissipator or heat sink (58).

6. The motor drive system of any one of the preceding claims, in which the dissipative element (Rx) is a power resistor.

7. The motor drive system of any one of the preceding claims, the
dissipative element (Rx) having a first terminal connected to a first one of the positive or negative input or output terminals (91a, 91b, 92a, 92b) having a first polarity, and at least one switch (71a,71b), selectively controllable by a signal (103) for connecting a second terminal of the dissipative element (Rx) with a second one of the positive or negative input or output terminals (91a, 91b, 92a, 92b) having a polarity opposite to the first polarity.

8. The motor drive system of the preceding claim wherein the switch (71b) is included in the filter (50) and has one terminal connected to the second terminal of the dissipative element (Rx), and a terminal connected to the second one of the positive or negative input or output terminals (91a, 91b, 92a, 92b), and the signal is available at a discharge signal terminal (54b) of the filter (50).

9. The motor drive system of claim 7, wherein the switch (71a) is a component external to the filter (50) and has one terminal connected to the second terminal of the dissipative element (Rx) through a discharge terminal (54a) of the filter (50).

## Patentansprüche

1. Motorantriebssystem (50, 60) für ein Elektrofahrzeug, umfassend
eine Motorantriebeinheit (60) und ein Filter (50), und zur Verbindung mit einer Gleichstromversorgungsleitung (15) über das Filter konfiguriert,
wobei das Filter positive und negative Eingangsanschlüsse (91a, 92a) zur Verbindung des Filters mit der Gleichstromversorgungsleitung sowie positive und negative Ausgangsanschlüsse (91b, 92b) zur Verbindung des Filters mit der Motorantriebeinheit umfasst,
ein Filterkreis (51), welches zur Filtrierung einer Rauschkomponente auf der Gleichstromversorgungsleitung (15) angeordnet ist,
**gekennzeichnet durch** ein dissipatives Element (Rx) im Filter (50), welches wahlweise zwischen einem positiven Eingangs- oder Ausgangsanschluss (91a, 91b) und einem jeweiligen negativen Eingangs- oder Ausgangsanschluss (92a, 92b) verbindbar ist,
worin das dissipative Element (Rx) in thermischem Kontakt mit einem Wärmeableiter steht, welche ein metallisches Gehäuse des Filters (50) ist,
wobei das Filter (50) an einem metallischen Gehäuse der Motorantriebeinheit (60) befestigt ist, welches zur aktiven Kühlung ausgestaltet ist.

2. Motorantriebssystem gemäss dem vorhergehenden Anspruch, umfassend eine Schutzerdung (PE).

3. Motorantriebssystem gemäss irgendeinem der vorhergehenden Ansprüche, worin das dissipative Element (Rx) in thermischem Kontakt mit einer Wärmesenke (58) steht.

4. Motorantriebssystem gemäss dem vorhergehenden Anspruch, worin der Wärmeableiter oder die Wärmesenke (58) über ein wärmeleitendes Gehäuse des Filters (50) in thermischem Kontakt mit dem dissipativen Element (Rx) steht.

5. Motorantriebssystem gemäss irgendeinem der Ansprüche 3 bis 4, worin das Filter ferner eine thermische Unterlage oder eine thermische Paste umfasst, welche zwischen dem dissipativen Element (Rx) und dem Wärmeableiter oder der Wärmesenke (58) angeordnet ist.

6. Motorantriebssystem gemäss irgendeinem der vorhergehenden Ansprüche, worin das dissipative Element (Rx) ein Leistungswiderstand ist.

7. Motorantriebssystem gemäss irgendeinem der vorhergehenden Ansprüche, wobei das dissipative Element (Rx) einen ersten Anschluss aufweist, welcher mit einem ersten der positiven oder negativen Eingangs- oder Ausgangsanschlüsse (91a, 91b, 92a, 92b) mit einer ersten Polarität verbunden ist, und mindestens einen Schalter (71a, 71b), welcher wahlweise durch ein Signal (103) steuerbar ist, um einen zweiten Anschluss des dissipativen Elements (Rx) mit einem zweiten der positiven oder negativen Eingangs- oder Ausgangsanschlüsse (91a, 91b, 92a, 92b) mit einer zur ersten Polarität entgegengesetzten Polarität zu verbinden.

8. Motorantriebssystem gemäss dem vorhergehenden Anspruch, worin der Schalter (71b) im Filter (50) integriert ist und einen Anschluss aufweist, welcher mit dem zweiten Anschluss des dissipativen Elements (Rx) verbunden ist, sowie einen Anschluss, welcher mit dem zweiten der positiven oder negativen Eingangs- oder Ausgangsanschlüsse (91a, 91b, 92a, 92b) verbunden ist, und wobei das Signal an einem Entladungssignalanschluss (54b) des Filters (50) verfügbar ist.

9. Motorantriebssystem gemäss Anspruch 7, worin der Schalter (71a) eine externe Komponente zum Filter (50) ist und einen Anschluss aufweist, welcher über einen Entladungsanschluss (54a) des Filters (50) mit dem zweiten Anschluss des dissipativen Elements (Rx) verbunden ist.

## Revendications

1. Un système de contrôle de moteur (50, 60) pour un véhicule électrique, comprenant une unité de contrôle de moteur (60) et un filtre (50) et étant configuré pour être connecté à une ligne d'alimentation en courant continu CC (15) via le filtre, le filtre comprenant des bornes d'entrée positives et négatives (91a, 92a) pour connecter le filtre à la ligne d'alimentation CC, et des bornes de sortie positives et négatives (91b, 92b) pour connecter le filtre à l'unité de contrôle de moteur, un circuit de filtrage (51) agencé pour filtrer une composante de bruit sur la ligne d'alimentation CC (15), **caractérisé par** un élément dissipatif (Rx) dans le filtre (50), lequel est connectable sélectivement entre une borne d'entrée ou de sortie positive (91a, 91b) et une borne d'entrée ou de sortie négative respective (92a, 92b), l'élément dissipatif (Rx) étant en contact thermique avec un dissipateur thermique qui est une enceinte métallique du filtre (50), le filtre (50) étant fixé à une enceinte métallique de l'unité de contrôle de moteur (60) qui est configurée pour être refroidie activement.

2. Le système de contrôle de moteur de la revendication précédente, comprenant une terre de protection (PE).

3. Le système de contrôle de moteur de l'une quelconque des revendications précédentes, dans lequel l'élément dissipatif (Rx) est en contact thermique avec un une masse thermique (58).

4. Le système de contrôle de moteur de la revendication précédente, dans lequel le dissipateur thermique ou la masse thermiques est en contact thermique avec l'élément dissipatif (Rx) à travers une enceinte du filtre (50) thermoconductrice.

5. Le système de contrôle de moteur de l'une quelconque des revendications 3 ou 4, dans lequel le filtre comprend en outre un pad thermique ou une pâte thermique disposé(e) entre l'élément dissipatif (Rx) et le dissipateur thermique ou dissipateur de chaleur (58).

6. Le système de contrôle de moteur de l'une quelconque des revendications précédentes, dans lequel l'élément dissipatif (Rx) est une résistance de puissance.

7. Le système de contrôle de moteur de l'une quelconque des revendications précédentes, l'élément dissipatif (Rx) ayant une première borne connectée à l'une des bornes d'entrée ou de sortie positives ou négatives (91a, 91b, 92a, 92b) ayant une première polarité, et au moins un interrupteur (71a, 71b), commandable sélectivement par un signal (103), pour connecter une seconde borne de l'élément dissipatif (Rx) à une autre des bornes d'entrée ou de sortie positives ou négatives (91a, 91b, 92a, 92b) ayant une polarité opposée à la première polarité

8. Le système de contrôle de moteur de la revendication précédente, dans lequel l'interrupteur (71b) est inclus dans le filtre (50) et présente une borne connectée à la seconde borne de l'élément dissipatif (Rx), et une borne connectée à ladite autre des bornes d'entrée ou de sortie positives ou négatives (91a, 91b, 92a, 92b), et dans lequel le signal est disponible à une borne de signal de décharge (54b) du filtre (50).

9. Le système de contrôle de moteur de la revendication 7, dans lequel l'interrupteur (71a) est un composant externe au filtre (50) et présente une borne connectée à la seconde borne de l'élément dissipatif (Rx) via une borne de décharge (54a) du filtre (50).
